# EUROPEAN PATENT APPLICATION

(11) **EP 2 053 738 A1**
(43) Date of publication of application: **29.04.2009**
(21) Application number: 07291295.9
(22) Date of filing: 25.10.2007
(51) Int. Cl.: H03F 1/02, H03F 1/42, H03F 1/56

(54) **Amplifier with adjustable frequency band**

(71) Applicant: Alcatel Lucent, 75008 Paris (FR)
(72) Inventor: Pascht, Andreas, 73614 Schorndorf (DE)
(74) Representative: Richardt, Markus Albert

(57) **Abstract**

The invention relates to an amplifier with a first electric line (119) having a first frequency-dependent electric length and a second electric line (123) having a second frequency dependent length, the first electric line (119) being electrically connectable to an input (117) of the amplifier and the second electric line (123) being electrically connectable to an output (121) of the amplifier to adjust a frequency for amplification

## Description

The present invention relates to an amplifier with an adjustable frequency band, in particular to a multi-band amplifier.

In order to amplify signals in different frequency bands, a multi-band amplifier, e.g. a Doherty amplifier used as power amplifier for radio frequency applications, may be employed. However, the efficiency of multi-band amplifiers is reduced when compared to small band amplifiers.

It is the object of the invention to provide an amplifier for a multi-band amplification with an increased efficiency.

This object is achieved by the features of the independent claims.

The invention is based on the finding that an efficient amplification in a multi-band scenario can be achieved when connecting electric lines having a predetermined electric length associated with a certain frequency to an input and an output of an amplifier, respectively. In order to cover a plurality of sub-bands of a multi-band spectrum, a plurality of sets of electric lines may be provided, each set of electric liners being e.g. associated with a certain frequency.

By way of example, the amplifier has the Doherty architecture or any other architecture, wherein the frequency determination is performed using e.g. lambda quarter lines, lambda being a wavelength associated with a frequency. For example, different sets of lambda quarter lines at the input and at the output of the Doherty architecture may be used, wherein for each desired frequency band a lambda quarter set may be defined, so that the frequency band can be selected e.g. by electrical switches connecting the respective lambda quarter set to the input and to the output of the amplifier. Thus, the inventive concept may also be employed in software defined radio approaches where e.g. controllable switches are provided for selecting a respective electric line set, e.g. a respective lambda quarter set. Moreover, the efficiency comparable with small band approaches at prices comparable with small band designs may be achieved. Furthermore, the inventive amplifier may also be employed in a WCDMA scenario (Wideband Code Division Multiplexing Access).

The invention relates to an amplifier with a first electric line having a first frequency-dependent electric length and a second electric line having a second frequency-dependent length. The first electric line is preferably electrically connectible to an input of the amplifier, wherein the second electric line is electrically connectible to an output of the amplifier in order to adjust a frequency or a frequency sub-band for amplification. Furthermore, the first and the second electric line may be switchably connectable to the amplifier.

According to an embodiment, the amplifier comprises a third electric line having a third frequency-dependent electric length and a fourth electric line having a fourth frequency-dependent electric length. Preferably, the third electric line is electrically connectible to the input and the fourth electric line is electrically connectible to the output in order to adjust a further frequency for amplification.

According to an embodiment, the amplifier may comprise a switch for switchably connecting the first electric line to the input and the second electric line to the output in order to adjust the frequency band and/or for a switchably connecting the third electric line and the fourth electric line to the output for adjusting a further frequency band. Preferably, the third and the fourth electric lines are disconnected from the amplifier when the first and the second electric lines are connected thereto. Correspondingly, the first and the second electric lines may be disconnected from the amplifier when the third and the fourth electric lines are connected thereto.

According to an embodiment, if e.g. the first and the second electric line are connected to the input and the output then a corresponding frequency band is adjusted for amplification. For example, the first and/or the third electric line may be arranged or switched between the input and a terminal of the amplifier wherein the second and/or the fourth electric line may be switched between another terminal of the amplifier and an output.

According to an embodiment, the electric lines which are simultaneously connected to the input and the output have equal electric lengths. Thus, a respective set of electric lines comprises two electric lines of equal electric lengths for adjusting a certain frequency.

According to an embodiment, the electric lengths are equal to or multiple of quarter wavelength which is associated with the desired frequency. When using e.g. quarter wavelength lines, an effective frequency adjustment may be achieved.

According to an embodiment, the first and the second electric line forms an electric line pair of a plurality of electric line pairs, each electric line pair being associated with different frequency. Preferably, the amplifier comprises a selector for selecting an electric line pair associated with a certain frequency. Thus, the electric line lengths are selectable by selecting different electric lines. Furthermore, the amplifier may comprise a memory for storing a plurality of frequencies associated with electric line pairs so that the certain frequency is uniquely associated with a certain electric line pair.

According to an embodiment, the amplifier has a Doherty structure and may be used for power amplifying.

According to an embodiment, the amplifier may comprise a first transistor and a second transistor, each transistor having a first terminal, e.g. a drain or a source, a second terminal, e.g. a source and a drain, and a control terminal, e.g. a gate, wherein the input of the amplifier is connected to the control terminal of the first transistor. Furthermore, the input and the control terminal of the second transistor are connectible by the first electric line and the first terminal of the first transistor and the first terminal of the second transistor are connectible by the second electric line or by the fourth electric line. For example, the first terminal of the second transistor may simultaneously form an output of the amplifier.

According to a further aspect, the invention relates to a base station for a multi-band operation, the base station comprising a transmitter or a receiver and the inventive amplifier for amplifying transmit or receive signals.

According to a further aspect, the invention relates to a a communication network entity for receiving or transmitting or forwarding signals, the communication network entity comprising the inventive amplifier.

According to a further aspect, the invention relates to a method for adjusting a frequency for amplification by an amplifier with a first electric line having a first frequency-dependent electric length and a second electric line having a second frequency-dependent length. The method comprises electrically connecting the first electric line to an input of the amplifier and electrically connecting the second electric line to an output of the amplifier to adjust the frequency for amplification. Further steps are derivable from the functionality of the inventive amplifier.

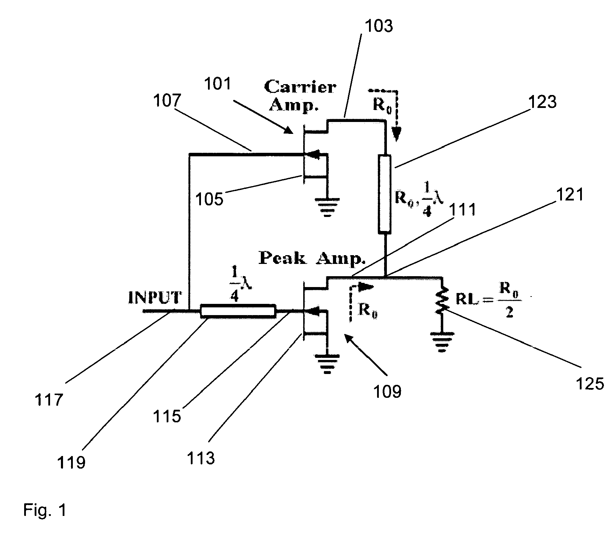

Further embodiments of the invention will be described with reference to Fig. 1 showing an amplifier according to an embodiment of the invention.

By way of example, the amplifier shown in Fig. 1 has a Doherty architecture and comprises a first transistor 101 having a first terminal 103, a second terminal 105 and a control terminal 107. The amplifier further comprises a second transistor 109 having a first terminal 111, a second terminal 113 and a control terminal 115.

The amplifier further comprises an input 117 connected to the control terminal 107 of the first transistor 101. The input 117 is further connectable to the control terminal 115 of the second transistor 109 by a first electric line 119.

The amplifier further comprises an output 121 wherein the first terminal 103 of the first transistor 101 is connectable to the output 121 by a second electric line 123. The output 121 is further connected to the first terminal 111 of the first transistor 109 and via a resistor 125 to ground. The second terminals 105 and 113 are connected to ground and, optionally, to a respective bulk-terminal of the respective transistor 101, 109.

The first electric line 119 and the second electric line 123 have for example a resistance of R₀ and an electric length equal to a quarter wavelength λ.

As depicted if Fig. 1, a small-band Doherty amplifier may be used for amplifying within different frequency bands of a multi-band scenario when different lambda-quarter lines at the input and at the output are selected by e.g. switches in dependence on the desired frequency band. The electric lines 119 and 123 may have the above outlined characteristics and may be switchable by a switch which is not depicted in Fig. 1. Furthermore, further electric line sets associated with different electric lengths may be provided such that another electric line set may switchably replace the electric line set depicted in Fig. 1 for adjusting another frequency. Correspondingly, the resistor 125 having a resistance of RL = R₀/2 may also be switchably replaced for each pair of electric lines by a resistor associated with the respective wavelength.

In operation, a carrier amplitude at the input is provided to the control terminal of the first transistor 103, wherein a peak amplitude is provided via the first electric line 119 to the control terminal 115 of the second transistor 105. The electric line set adjusts the frequency so that a small band operation in the desired frequency band is achieved.

For example, the amplifier depicted in Fig. 1 may comprise only one switch for switching a respective electric line set according to the predetermined frequency. Furthermore, the amplifier may comprise a switch at the input and a switch at the output, wherein each of the switches can be used for selecting e.g. a dedicated lambda quarter line out of a plurality of different lambda quarter lines for frequency adjustment. The inventive amplifier may be employed in base stations or in communication networks for amplifying or forwarding receive or transmit signals, wherein, due to the electric line selection, a certain frequency at a certain time instant may be adjusted.

### List of reference numerals

- 101: first transistor
- 103: first terminal
- 105: second terminal
- 107: control terminal
- 109: second transistor
- 111: first terminal
- 113: second terminal
- 115: control terminal
- 117: input
- 119: first electric line
- 121: output
- 123: second electric line
- 125: resistor

## Claims

1. An amplifier, comprising:
a first electric line (119) having a first frequency-dependent electric length;
a second electric line (123) having a second frequency dependent length;
the first electric line (119) being electrically connectable to an input (117) of the amplifier and the second electric line (123) being electrically connectable to an output (121) of the amplifier to adjust a frequency for amplification.

2. The amplifier according to claim 1, comprising a third electric line having a third frequency-dependent electric length and a fourth electric line having a fourth frequency-dependent electric length, the third electric line being electrically connectable to the input (117), the fourth electric line being electrically connectable to the output (121) to adjust a further frequency for amplification.

3. The amplifier according to claim 1 or 2, comprising a switch for switchably connecting the first electric line (119) to the input (117) and the second electric line (123) to the output (121) for adjusting the frequency or for switchably connecting a third electric line having a third frequency-dependent electric length to the input (117) and a fourth electric line having a fourth frequency-dependent electric length to the output (121) for adjusting a further frequency for amplification.

4. The amplifier according to anyone of the claims 1 to 3, the electric lengths being equal to or a multiple of a quarter wave length associated with the frequency.

5. The amplifier according to anyone of the claims 1 to 4, the first electric line (117) and the second electric line (121) forming an electric line pair of a plurality of electric line pairs, each electric line pair being associated with different frequency, the amplifier further comprising a selector for selecting an electric line pair associated with a certain frequency.

6. The amplifier according to anyone of the claims 1 to 5, the first electric line (117) and the second electric line (121) forming an electric line pair of a plurality of electric line pairs, each electric line pair being associated with different frequency for amplification, the amplifier further comprising a memory element for storing a plurality of different frequencies associated with corresponding electric line pairs.

7. The amplifier according to anyone of the claims 1 to 6, further comprising:
a first transistor (101) having a first terminal (103), a second terminal (105) and a control terminal (107);
a second transistor (109) having a first terminal (111), a second terminal (113) and a control terminal (115);
the input (117) being connected to the control terminal (107) of the first transistor (101), the input (117) and the control terminal (115) of the second transistor (109) being connectable by the first electric line (117), the first terminals (103, 111) of the first and second transistor (101, 109) being connectable by the second electric line (123).

8. A base station comprising the amplifier according to anyone of the claims 1 to 7 for amplifying transmit or receive signals.

9. A communication network entity for receiving or transmitting or forwarding signals, the communication network entity comprising the amplifier according to anyone of the claims 1 to 7.

10. A method for adjusting a frequency for amplification by an amplifier with a first electric line having a first frequency-dependent electric length and a second electric line having a second frequency dependent length, the method comprising:
electrically connecting the first electric line to an input of the amplifier and electrically connecting the second electric line to an output of the amplifier to adjust the frequency for amplification.
